# EUROPEAN PATENT SPECIFICATION

(11) **EP 4 322 330 B1**
(45) Date of publication and mention of the grant of the patent: **25.11.2026**
(21) Application number: 22784665.6
(22) Date of filing: 04.04.2022
(51) Int. Cl.: H01Q 1/38, H01Q 21/28, H05K 1/02, H05K 1/16

(54) **WIRING BOARD AND METHOD OF MANUFACTURING A WIRING BOARD**
LEITERPLATTE UND VERFAHREN ZUR HERSTELLUNG EINER LEITERPLATTE
CARTE DE CÂBLAGE ET PROCÉDÉ DE FABRICATION D'UNE CARTE DE CÂBLAGE

(30) Priority: 09.04.2021 JP 2021066761
(43) Date of publication of application: 14.02.2024
(73) Proprietor: Dai Nippon Printing Co., Ltd., Tokyo 162-8001 (JP)
(72) Inventor: IIMURA Keita, Tokyo 162-8001 (JP); KAWAGUCHI Shuji, Tokyo 162-8001 (JP); KINOSHITA Kazuki, Tokyo 162-8001 (JP); IIOKA Hidetoshi, Tokyo 162-8001 (JP); TAKE Seiji, Tokyo 162-8001 (JP)
(74) Representative: Müller-Boré & Partner Patentanwälte PartG mbB
(86) International application number: PCT/JP2022/017051
(87) International publication number: WO 2022/215683

(56) References cited:
- JP-A- 2018 060 345
- JP-A- 2020 036 031
- KR-A- 20200 117 481
- KR-A- 20210 034 577
- US-A1- 2016 093 939

## Description

### Technical Field

Embodiments of the present disclosure relates to a wiring board and a method of manufacturing the wiring board.

### Background Art

These days, portable terminal devices such as smartphones and tablets are becoming more and more sophisticated in functionality, smaller in size, thinner in profile, and lighter in weight. These portable terminal devices use a plurality of communication bands, and therefore require a plurality of antennas corresponding to the communication bands. For example, a portable terminal device is equipped with a plurality of antennas such as a phone antenna, a wireless fidelity (Wi-Fi) antenna, a third generation (3G) antenna, a fourth generation (4G) antenna, a long term evolution (LTE) antenna, a Bluetooth^{®} antenna, and a near field communication (NFC) antenna. However, as portable terminal devices are becoming smaller, it imposes a limitation on an antenna mounting space and reduces antenna design flexibility. Moreover, since the antennas are provided in a limited space, radio sensitivity is not always satisfactory.

To address this issue, film antennas mountable in a display region of a portable terminal device have been developed. A film antenna has a structure in which, in a transparent antenna including a transparent base substrate on which an antenna pattern is formed, the antenna pattern is formed of a conductor mesh layer having a mesh structure including a conductor portion where an opaque conductor layer is formed and many openings where no such conductor is formed.

### Citation List

### Patent Literature

Patent Literature 1: Japanese Unexamined Patent Application Publication No. 2011-66610
Patent Literature 2: Specification of Japanese Patent No. 5636735
Patent Literature 3: Specification of Japanese Patent No. 5695947
Patent Literature 4: JP 2020 036031 A
Patent Literature 5: KR 2020 0117481 A
Patent Literature 6: US 2016/093939 A1

By the way, for example, in a film antenna according to related art, a single mesh antenna, or a plurality of mesh antennas, is mounted on a transparent base substrate, and there exist both an area where an antenna pattern is formed on the transparent base substrate and an area where no antenna pattern is formed on the transparent base substrate. In this case, the presence of the area where no antenna pattern is formed makes it easier for the area where the antenna pattern is formed to be visually noticed. Therefore, a solution for making it harder for a wiring pattern such as an antenna pattern to be visually noticed is demanded. Patent Literatures 4-6 disclose a mesh antenna surrounded by a dummy mesh comprising isolated mesh patterns.

One of objects of the present embodiment is to provide a wiring board that makes it harder for a mesh wiring portion to be visually noticed, and a method of manufacturing the wiring board.

### Summary of Invention

A wiring board according to an embodiment of the present disclosure is a wiring board that includes: a substrate having transparency; a mesh wiring portion arranged on the substrate and including a plurality of wiring lines; and a dummy wiring portion arranged around the mesh wiring portion and including a plurality of dummy wiring lines electrically independent of the wiring lines, wherein the mesh wiring portion is comprised of an iterative array of a predetermined unit pattern in a first direction, the dummy wiring portion is comprised of a plurality of isolated patterns independent of one another, the isolated patterns have the same shape as one another, at the isolated pattern, openings are formed by being surrounded by the dummy wiring lines, a length of the dummy wiring line of the isolated pattern is 4.0 times or less a length of the wiring line of the unit pattern, and in the first direction, a gap between the isolated patterns is 0.01 times or more and 0.2 times or less a pitch of the unit pattern in the first direction.

In the wiring board according to an embodiment of the present disclosure, in the first direction, a gap between the mesh wiring portion and the dummy wiring portion may be 0.01 times or more and 0.2 times or less a pitch of the unit pattern in the first direction.

In the wiring board according to an embodiment of the present disclosure, the unit pattern may be arranged iteratively in a second direction different from the first direction, and in the second direction, a gap between the isolated patterns may be 0.01 times or more and 0.2 times or less a pitch of the unit pattern in the second direction.

In the wiring board according to an embodiment of the present disclosure, in the second direction, a gap between the mesh wiring portion and the dummy wiring portion may be 0.01 times or more and 0.2 times or less a pitch of the unit pattern in the second direction.

In the wiring board according to an embodiment of the present disclosure, the isolated pattern may include a dummy unit pattern, and a shape of the dummy unit pattern may be identical to a shape of the unit pattern.

The wiring board according to an embodiment of the present disclosure may have a radio-wave transmitting-and-receiving function.

A method of manufacturing a wiring board according to an embodiment of the present disclosure includes: preparing a substrate having transparency; and forming a mesh wiring portion and a dummy wiring portion on the substrate, the mesh wiring portion including a plurality of wiring lines, the dummy wiring portion being arranged around the mesh wiring portion and including a plurality of dummy wiring lines electrically independent of the wiring lines, wherein the mesh wiring portion is comprised of an iterative array of a predetermined unit pattern in a first direction, the dummy wiring portion is comprised of isolated patterns independent of one another, the isolated patterns have the same shape as one another, at the isolated pattern, openings are formed by being surrounded by the dummy wiring lines, a length of the isolated pattern is 4.0 times or less a length of the unit pattern, and in the first direction, a gap between the isolated patterns is 0.01 times or more and 0.2 times or less a pitch of the unit pattern in the first direction.

With the embodiment of the present disclosure, it is possible to make it harder for a mesh wiring portion to be visually noticed.

### Brief Description of Drawings

[Fig. 1] Fig. 1 is a plan view of a wiring board according to a first embodiment.
[Fig. 2A] Fig. 2A is an enlarged plan view of a wiring board according to the first embodiment (an enlarged view of a part IIA in Fig. 1).
[Fig. 2B] Fig. 2B is an enlarged plan view of a wiring board according to the first embodiment (an enlarged view of a part IIB in Fig. 1).
[Fig. 3] Fig. 3 is a cross-sectional view of a wiring board according to the first embodiment (a cross-sectional view taken along the line III-III in Fig. 2A).
[Fig. 4] Fig. 4 is a cross-sectional view of a wiring board according to the first embodiment (a cross-sectional view taken along the line IV-IV in Fig. 2A).
[Fig. 5] Fig. 5 is a cross-sectional view of a wiring board according to the first embodiment (a cross-sectional view taken along the line V-V in Fig. 2A).
[Fig. 6A] Fig. 6A is a cross-sectional view illustrating a method of manufacturing a wiring board according to the first embodiment.
[Fig. 6B] Fig. 6B is a cross-sectional view illustrating the method of manufacturing a wiring board according to the first embodiment.
[Fig. 6C] Fig. 6C is a cross-sectional view illustrating the method of manufacturing a wiring board according to the first embodiment.
[Fig. 6D] Fig. 6D is a cross-sectional view illustrating the method of manufacturing a wiring board according to the first embodiment.
[Fig. 6E] Fig. 6E is a cross-sectional view illustrating the method of manufacturing a wiring board according to the first embodiment.
[Fig. 7] Fig. 7 is a plan view of an image display device according to the first embodiment.
[Fig. 8A] Fig. 8A is a plan view of a wiring board according to a modification example of the first embodiment (a diagram corresponding to Fig. 2A).
[Fig. 8B] Fig. 8B is a plan view of a wiring board according to a modification example of the first embodiment (a diagram corresponding to Fig. 2B).
[Fig. 9A] Fig. 9A is an enlarged plan view of a wiring board according to a second embodiment (a diagram corresponding to Fig. 2A).
[Fig. 9B] Fig. 9B is an enlarged plan view of a wiring board according to the second embodiment (a diagram corresponding to Fig. 2B).
[Fig. 10A] Fig. 10A is a plan view illustrating an isolated pattern of a wiring board according to a modification example of the second embodiment.
[Fig. 10B] Fig. 10B is a plan view illustrating an isolated pattern of a wiring board according to a modification example of the second embodiment.
[Fig. 10C] Fig. 10C is a plan view illustrating an isolated pattern of a wiring board according to a modification example of the second embodiment.
[Fig. 10D] Fig. 10D is a plan view illustrating an isolated pattern of a wiring board according to a modification example of the second embodiment.

### Description of Embodiments

### First Embodiment

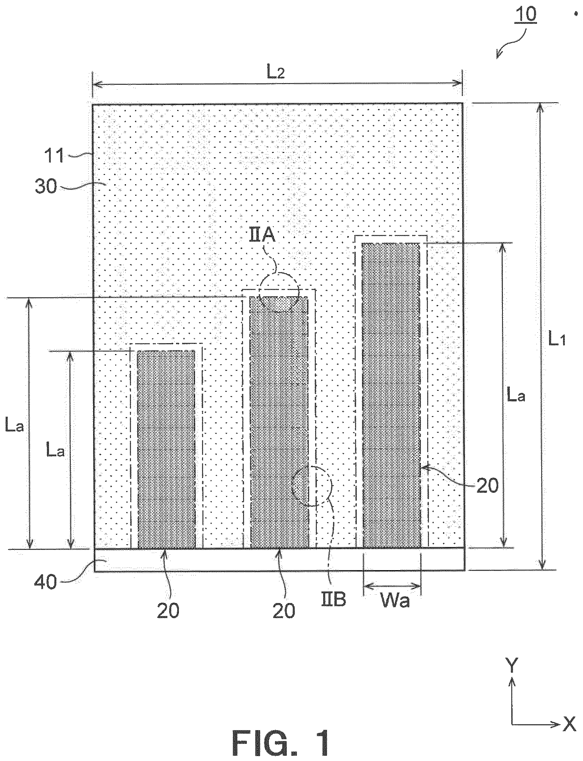

First, with reference to Figs. 1 to 7, a first embodiment will now be described. Figs. 1 to 7 are diagrams illustrating a first embodiment.

The drawings mentioned below are schematic. Therefore, the illustration will be exaggerated where appropriate in order to facilitate understanding of sizes/shapes of portions. Modifications can be made as appropriate within a range of not departing from the technical idea. In the drawings mentioned below, the same reference signs will be assigned to the same portions, and detailed description may be partially omitted. Numerical values such as dimensions of members described in this specification, and material names thereof, are just examples in the embodiments, and selection can be made as appropriate without any limitation to them. In this specification, terms that specify shapes and geometric conditions, for example, "parallel", "orthogonal", "perpendicular", and the like, shall be construed not only in a strict sense but also in a sense of being deemed to be substantially the same as their exact definitions.

In the present embodiment, the term "X direction" means a direction perpendicular to a longer-side direction of a mesh wiring portion and perpendicular to a direction of a length corresponding to a frequency band of a first-direction wiring line. The term "Y direction" means a direction perpendicular to the X direction and parallel to the longer-side direction of the mesh wiring portion and parallel to the direction of the length corresponding to the frequency band of the first-direction wiring line. The term "Z direction" means a direction perpendicular to both the X direction and the Y direction and parallel to a thickness direction of a wiring board. The term "front surface" means a surface which is on a positive side in the Z direction and on which, with respect to the substrate, first-direction wiring lines are provided. The term "back surface" means a surface which is on a negative side in the Z direction and is the opposite of the surface on which, with respect to the substrate, the first-direction wiring lines are provided. In the present embodiment, a description will be given while taking, as an example, a case where a mesh wiring portion 20 is a mesh wiring portion 20 having a radio-wave transmitting-and-receiving function (a function to serve as an antenna). However, the mesh wiring portion 20 does not necessarily have to have the radio-wave transmitting-and-receiving function (the function to serve as an antenna).

### [Configuration of Wiring Board]

With reference to Figs. 1 to 5, a configuration of a wiring board according to the present embodiment will now be described. Figs. 1 to 5 are diagrams illustrating a wiring board according to the present embodiment.

As illustrated in Fig. 1, a wiring board 10 according to the present embodiment is disposed on, for example, a display of an image display device. The wiring board 10 includes a substrate 11 that has transparency, a mesh wiring portion(s) 20 arranged on the substrate 11, and a dummy wiring portion 30 arranged around the mesh wiring portion 20 on the substrate 11. A power feeding portion 40 is electrically connected to the mesh wiring portion 20.

The substrate 11 has a substantially rectangular shape in a plan view. Its longer-side direction is parallel to the Y direction. Its shorter-side direction is parallel to the X direction. The substrate 11 has transparency and is substantially flat. Its thickness is substantially uniform as a whole. The length L₁ of the substrate 11 in its longer-side direction (Y direction) can be selected within a range from, for example, 10 mm inclusive to 200 mm inclusive. The length L₂ of the substrate 11 in its shorter-side direction (X direction) can be selected within a range from, for example, 3 mm inclusive to 100 mm inclusive.

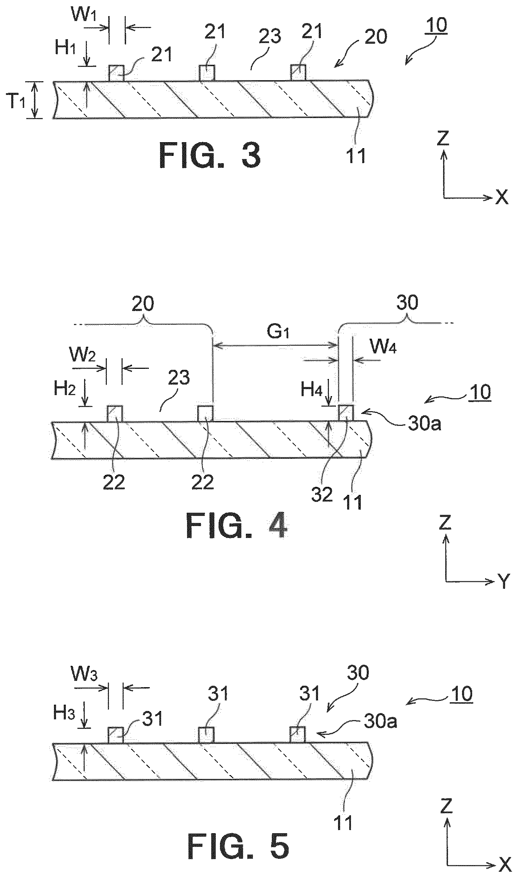

The material of the substrate 11 may be any material as long as it has transparency in the spectrum of visible light and has electric insulation property. In the present embodiment, the material of the substrate 11 is polyethylene terephthalate, but is not limited thereto. As the material of the substrate 11, it is preferable to use an organic insulating material such as a polyester-based resin, an acryl-based resin, a polycarbonate-based resin, a polyimide-based resin, a polyolefin-based resin, a cellulose-based resin, or the like. The polyester-based resin may be polyethylene terephthalate or the like. The acryl-based resin may be polymethyl methacrylate or the like. The polyolefin-based resin may be a cycloolefin polymer or the like. The cellulose-based resin may be triacetyl cellulose or the like. Glass, ceramics, or the like can be selected as the material of the substrate 11, depending on the intended use. In the illustrated example, the substrate 11 has a single-layer structure, but is not limited thereto; it may have a structure made up of a plurality of bases or a multilayer structure. The substrate 11 may be like a film or like a plate. Therefore, the thickness of the substrate 11 is not specifically limited, and a selection can be made as appropriate, depending on the intended use. As one example, the substrate 11 can have a thickness T₁ (a length in the Z direction, see Fig. 3) that is within a range from, for example, 10 µm inclusive to 200 µm inclusive.

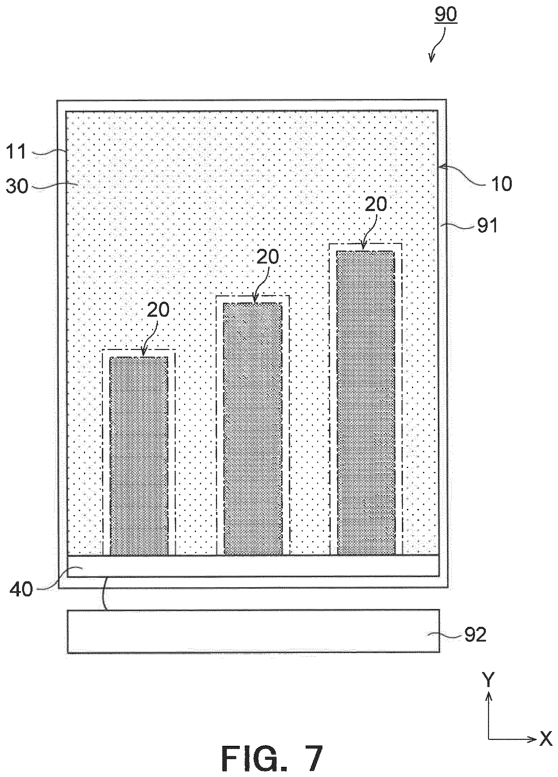

In Fig. 1, there exists a plurality of (three) mesh wiring portions 20 on the substrate 11. They correspond to frequency bands different from one another. That is, these mesh wiring portions 20 have lengths Lₐ (lengths in the Y direction) different from one another and corresponding to their respective specific frequency bands. The lower the corresponding frequency band is, the greater the length Lₐ of the mesh wiring portion 20 is. For example, in a case where the wiring board 10 is disposed on a display 91 of an image display device 90 (see Fig. 7, which will be described later), the wiring board 10 may have a radio-wave transmitting-and-receiving function at each of the mesh wiring portions 20. In this case, each of the mesh wiring portions 20 may correspond to any of a phone antenna, a Wi-Fi antenna, a 3G antenna, a 4G antenna, an LTE antenna, a Bluetooth^{®} antenna, an NFC antenna, and the like. Alternatively, in a case where the wiring board 10 does not have a radio-wave transmitting-and-receiving function, each of the mesh wiring portions 20 may fulfill, for example, a hovering function (a function of enabling the user to operate a display without touching it directly), a fingerprint authentication function, a heater function, a noise-cut (shield) function, or the like.

Each of the mesh wiring portions 20 has a substantially rectangular shape in a plan view. The longer-side direction of each of the mesh wiring portions 20 is parallel to the Y direction, and the shorter-side direction thereof is parallel to the X direction. The length Lₐ of each of the mesh wiring portions 20 in its longer-side direction (Y direction) can be selected within a range from, for example, 3 mm inclusive to 100 mm inclusive. The width Wₐ of each of the mesh wiring portions 20 in its shorter-side direction (X direction) can be selected within a range from, for example, 1 mm inclusive to 10 mm inclusive.

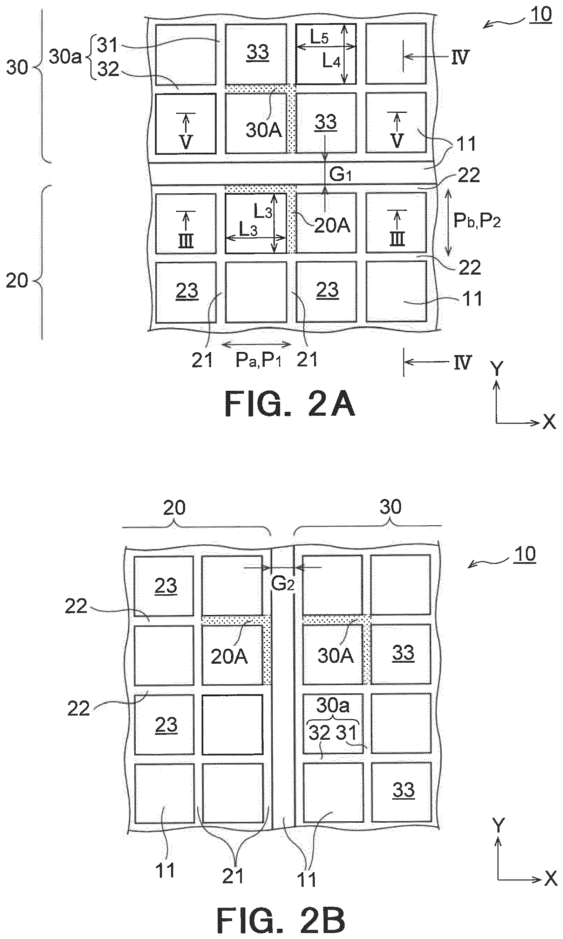

The mesh wiring portion 20 is comprised of an iterative array of a predetermined unit pattern 20A in a first direction (for example, the Y direction). In addition, the unit pattern 20A is arranged iteratively in a second direction (for example, the X direction) different from the first direction. In other words, the mesh wiring portion 20 each has a grid shape or a mesh shape formed of metal lines and has a uniform iterative pattern in the X direction and the Y direction. In this case, as illustrated in Figs. 2A and 2B, the mesh wiring portion 20 is configured as iteration of the L-shaped unit pattern 20A (a halftone-dotted portion in Figs. 2A and 2B). The L-shaped unit pattern 20 is made up of a portion extending in the X direction (a part of a second-direction wiring line 22 to be described later) and a portion extending in the Y direction (a part of a first-direction wiring line 21 to be described later). Therefore, in the present embodiment, the pitch Pₐ of the unit pattern 20A in the X direction is equal to the pitch P₁ of the first-direction wiring lines 21 to be described later. For example, this pitch can be set within a range from 0.01 mm inclusive to 1 mm inclusive. Moreover, the pitch P_{b} of the unit pattern 20A in the Y direction is equal to the pitch P₂ of the second-direction wiring lines 22 to be described later. For example, this pitch can be set within a range from 0.01 mm inclusive to 1 mm inclusive.

As illustrated in Figs. 2A and 2B, each of the mesh wiring portions 20 includes a plurality of wiring lines 21 and 22. In the present embodiment, each of the mesh wiring portions 20 includes a plurality of first-direction wiring lines (wiring lines) 21 having a function to serve as an antenna and a plurality of second-direction wiring lines (wiring lines) 22 interconnecting the plurality of first-direction wiring lines 21. Specifically, the plurality of first-direction wiring lines 21 and the plurality of second-direction wiring lines 22 form a regular array having a grid shape or a mesh shape as a whole. Each of the first-direction wiring lines 21 extends in the direction corresponding to the frequency band of the antenna (Y direction). Each of the second-direction wiring lines 22 extends in the direction orthogonal to the first-direction wiring lines 21 (X direction). By having the length Lₐ corresponding to the predetermined frequency band (the above-mentioned length of the mesh wiring portion 20), the first-direction wiring line 21 mainly fulfills a function to serve as an antenna. On the other hand, by interconnecting these first-direction wiring lines 21, the second-direction wiring line 22 plays a role of preventing or reducing problems such as the breaking of the first-direction wiring line 21 or electric disconnection between the first-direction wiring line 21 and the power feeding portion 40.

At each of the mesh wiring portions 20, a plurality of openings 23 is formed by being surrounded by the first-direction wiring lines 21 arranged adjacent to one another and by the second-direction wiring lines 22 arranged adjacent to one another. The first-direction wiring lines 21 and the second-direction wiring lines 22 are arranged at equal intervals with respect to one another. That is, the plural first-direction wiring lines 21 are arranged at equal intervals with respect to one another, and the pitch P₁ (see Fig. 2A) of them can be selected within a range from, for example, 0.01 mm inclusive to 1 mm inclusive. The plural second-direction wiring lines 22 are arranged at equal intervals with respect to one another, and the pitch P₂ (see Fig. 2A) of them can be selected within a range from, for example, 0.01 mm inclusive to 1 mm inclusive. Arranging each of the plurality of first-direction wiring lines 21 and the plurality of second-direction wiring lines 22 at equal intervals as just described eliminates or reduces a variation in size among the openings 23 in each of the mesh wiring portions 20, thereby making it harder for the mesh wiring portion 20 to be noticed with the naked eye. Moreover, the pitch P₁ of the first-direction wiring lines 21 is equal to the pitch P₂ of the second-direction wiring lines 22. Therefore, each of the openings 23 has a substantially square shape in a plan view, and the substrate 11 having transparency is exposed through each of the openings 23. For this reason, it is possible to enhance the transparency of the wiring board 10 as a whole by increasing the area size of each of the openings 23. The length L₃ (see Fig. 2A) of one side of each of the openings 23 can be selected within a range from, for example, 0.01 mm inclusive to 1 mm inclusive. Each of the first-direction wiring lines 21 and each of the second-direction wiring lines 22 are orthogonal to each other; however, the two may intersect with each other at an acute angle or at an obtuse angle, without any limitation thereto. Each of the openings 23 may have a substantially rectangular shape or the like in a plan view. Furthermore, though it is preferable if the openings 23 have the same size and the same shape throughout the entire area, such uniformity throughout the entire area is not necessarily required; for example, the size and/or shape of them may vary from position to position.

As illustrated in Fig. 3, each of the first-direction wiring lines 21 has a substantially rectangular shape or a substantially square shape in cross section (X-directional cross section) perpendicular to its longer-side direction. In this case, the cross-sectional shape of the first-direction wiring line 21 is substantially uniform in the longer-side direction (Y direction) of the first-direction wiring line 21. In addition, as illustrated in Fig. 4, each of the second-direction wiring lines 22 has a substantially rectangular shape or a substantially square shape in cross section (Y-directional cross section) perpendicular to its longer-side direction, and this cross-sectional shape is substantially the same as the cross-sectional shape (X-directional cross-sectional shape) of the first-direction wiring line 21 described above. In this case, the cross-sectional shape of the second-direction wiring line 22 is substantially uniform in the longer-side direction (X direction) of the second-direction wiring line 22. The cross-sectional shape of the first-direction wiring line 21 and the second-direction wiring line 22 does not necessarily have to be a substantially rectangular shape or a substantially square shape. For example, the shape may be substantially trapezoidal such that its front face (the positive side in the Z direction) is narrower than its back face (the negative side in the Z direction) or may have curved lateral faces at both sides in the width direction.

In the present embodiment, the line width W₁ (the length in the X direction, see Fig. 3) of the first-direction wiring line 21 and the line width W₂ (the length in the Y direction, see Fig. 4) of the second-direction wiring line 22 are not specifically limited, and can be selected as appropriate, depending on the intended use. For example, the line width W₁ of the first-direction wiring line 21 can be selected within a range from 0.1 µm inclusive to 5.0 µm inclusive, and the line width W₂ of the second-direction wiring line 22 can be selected within a range from 0.1 µm inclusive to 5.0 µm inclusive. Moreover, the height H₁ (the length in the Z direction, see Fig. 3) of the first-direction wiring line 21 and the height H₂ (the length in the Z direction, see Fig. 4) of the second-direction wiring line 22 are not specifically limited, and can be selected as appropriate, depending on the intended use, for example, within a range from 0.1 µm inclusive to 5.0 µm inclusive.

The material of the first-direction wiring line 21 and the second-direction wiring line 22 may be any metal material having conductivity. In the present embodiment, the material of the first-direction wiring line 21 and the second-direction wiring line 22 is copper but is not limited thereto. For example, a metal material such as gold, silver, copper, platinum, tin, aluminum, iron, nickel, or the like (including alloy) can be used as the material of the first-direction wiring line 21 and the second-direction wiring line 22.

Referring back to Fig. 1, the dummy wiring portion 30 is provided in such a way as to surround each of the mesh wiring portions 20. The dummy wiring portion 30 is provided in such a way as to surround all of the periphery sides (the positive side in the X direction, the negative side in the X direction, and the positive side in the Y direction) of each of the mesh wiring portions 20, except for the side where the power feeding portion 40 is located (the negative side in the Y direction). In this case, the dummy wiring portion 30 is arranged on the substrate 11 at substantially the entire area, except for the area of the mesh wiring portions 20 and the power feeding portion 40. Unlike the mesh wiring portions 20, the dummy wiring portion 30 never fulfills a function to serve as an antenna.

As illustrated in Figs. 2A and 2B, the dummy wiring portion 30 is comprised of an iterative array of a predetermined dummy unit pattern 30A (a halftone-dotted portion in Figs. 2A and 2B). The dummy unit pattern 30A has a shape like an alphabet L and is arranged iteratively in the first direction (for example, the Y direction) and the second direction (for example, the X direction). In other words, the dummy wiring portion 30 is configured as iteration of dummy wiring line 30a having a predetermined unit pattern. That is, the dummy wiring portion 30 includes a plurality of dummy wiring lines 30a having an identical shape, and each of the dummy wiring lines 30a is electrically independent of the mesh wiring portion 20 (the first-direction wiring line 21 and the second-direction wiring line 22) and the power feeding portion 40. Moreover, the plural dummy wiring lines 30a are arranged regularly throughout the entire area in the dummy wiring portion 30. The dummy wiring lines 30a have a grid shape or a mesh shape formed of metal lines and have a uniform iterative pattern in the X direction and the Y direction. That is, as illustrated in Figs. 2A and 2B, each of the dummy wiring lines 30a includes a first dummy wiring portion 31 extending in the Y direction and a second dummy wiring portion 32 extending in the X direction. Among them, the first dummy wiring portion 31 has a predetermined length L₄ (the length in the Y direction), and the second dummy wiring portion 32 has a predetermined length L₅ (the length in the X direction), and these lengths are equal to each other (L₄ = L₅).

In the present embodiment, the shape of the dummy unit pattern 30A is identical to the shape of the unit pattern 20A. In other words, the shape of the dummy wiring line 30a is identical to the shape of the unit pattern 20A of the mesh wiring portion 20 described above. Since the shape of the dummy unit pattern 30A is identical to the shape of the unit pattern 20A as just described, it is possible to make it harder for the difference between the mesh wiring portion 20 and the dummy wiring portion 30 to be visually perceived and thus make the mesh wiring portion 20 arranged on the substrate 11 more invisible.

At the dummy wiring portion 30, a plurality of openings 33 is formed by being surrounded by the first dummy wiring portions 31 arranged adjacent to one another and by the second dummy wiring portions 32 arranged adjacent to one another. The first dummy wiring portions 31 and the second dummy wiring portions 32 are arranged at equal intervals with respect to one another. Arranging each of the plurality of first dummy wiring portions 31 and the plurality of second dummy wiring portions 32 at equal intervals as just described eliminates or reduces a variation in size among the openings 33 in the dummy wiring portion 30, thereby making it harder for the dummy wiring portion 30 to be noticed with the naked eye.

The pitch of the first dummy wiring portions 31 may be equal to the pitch P₁ of the first-direction wiring lines 21 (see Fig. 2A). The pitch of the second dummy wiring portions 32 may be equal to the pitch P₂ of the second-direction wiring lines 22 (see Fig. 2A). Therefore, each of the openings 33 has a substantially square shape in a plan view, and the substrate 11 having transparency is exposed through each of the openings 33. For this reason, it is possible to enhance the transparency of the wiring board 10 as a whole by increasing the area size of each of the openings 33. Each of the first dummy wiring portions 31 and each of the second dummy wiring portions 32 are orthogonal to each other; however, the two may intersect with each other at an acute angle or at an obtuse angle, without any limitation thereto. Each of the openings 33 may have a substantially rectangular shape or the like in a plan view. Furthermore, though it is preferable if the openings 33 have the same size and the same shape throughout the entire area, such uniformity throughout the entire area is not necessarily required; for example, the size and/or shape of them may vary from position to position.

In Fig. 2A, the mesh wiring portion 20 and the dummy wiring portion 30 are located next to each other in the Y direction. The first dummy wiring portion 31 lies on an extension of the first-direction wiring line 21 near the boundary between the mesh wiring portion 20 and the dummy wiring portion 30. This makes it harder for the difference between the mesh wiring portion 20 and the dummy wiring portion 30 to be visually perceived in the Y direction.

Moreover, in Fig. 2B, the mesh wiring portion 20 and the dummy wiring portion 30 are located next to each other in the X direction. The second dummy wiring portion 32 lies on an extension of the second-direction wiring line 22 near the boundary between the mesh wiring portion 20 and the dummy wiring portion 30. This makes it harder for the difference between the mesh wiring portion 20 and the dummy wiring portion 30 to be visually perceived in the X direction.

Now, in the present embodiment, in the Y direction (first direction), the gap G₁ between the mesh wiring portion 20 and the dummy wiring portion 30 is 0.01 times or more and 0.2 times or less the pitch P_{b} of the unit pattern 20A in the Y direction (first direction). Since the gap G₁ is 0.01 times or more the pitch P_{b}, it is possible to effectively suppress the dummy wiring line 30a of the dummy wiring portion 30 from having an influence on the transmission and reception of a radio wave at the mesh wiring portion 20. For this reason, it is possible to suppress a decrease in antenna performance. Moreover, since the gap G₁ is 0.2 times or less the pitch P_{b}, it is possible to make it harder for the difference between the mesh wiring portion 20 and the dummy wiring portion 30 to be visually perceived in the Y direction.

Similarly, in the X direction (second direction), the gap G₂ between the mesh wiring portion 20 and the dummy wiring portion 30 is 0.01 times or more and 0.2 times or less the pitch Pₐ of the unit pattern 20A in the X direction (second direction). Since the gap G₂ is 0.01 times or more the pitch P₁, it is possible to effectively suppress the dummy wiring line 30a of the dummy wiring portion 30 from having an influence on the transmission and reception of a radio wave at the mesh wiring portion 20. For this reason, it is possible to suppress a decrease in antenna performance. Moreover, since the gap G₂ is 0.2 times or less the pitch Pₐ, it is possible to make it harder for the difference between the mesh wiring portion 20 and the dummy wiring portion 30 to be visually perceived in the X direction. In this case, the gap G₁ may be equal to the gap G₂ (G₁ = G₂).

As illustrated in Fig. 5, the first dummy wiring portion 31 of each of the dummy wiring lines 30a has a substantially rectangular shape or a substantially square shape in cross section (X-directional cross section) perpendicular to its longer-side direction (Y direction). In addition, as illustrated in Fig. 4, the second dummy wiring portion 32 of each of the dummy wiring lines 30a has a substantially rectangular shape or a substantially square shape in cross section (Y-directional cross section) perpendicular to its longer-side direction (X direction). In this case, the cross-sectional shape of the first dummy wiring portion 31 is substantially the same as the cross-sectional shape of the first-direction wiring line 21, and the cross-sectional shape of the second dummy wiring portion 32 is substantially the same as the cross-sectional shape of the second-direction wiring line 22.

In the present embodiment, the line width W₃ (the length in the X direction, see Fig. 5) of the first dummy wiring portion 31 is substantially the same as the line width W₁ of the first-direction wiring line 21, and the line width W₄ (the length in the Y direction, see Fig. 4) of the second dummy wiring portion 32 is substantially the same as the line width W₂ of the second-direction wiring line 22. Moreover, the height H₃ (the length in the Z direction, see Fig. 5) of the first dummy wiring portion 31 and the height H₄ (the length in the Z direction, see Fig. 4) of the second dummy wiring portion 32 are substantially the same as the height H₁ of the first-direction wiring line 21 and the height H₂ of the second-direction wiring line 22 respectively.

The same metal material as the material of the first-direction wiring line 21 and the material of the second-direction wiring line 22 can be used as the material of the dummy wiring line 30a.

By the way, in the present embodiment, each of the mesh wiring portion 20 and the dummy wiring portion 30 has a predetermined aperture ratio. The aperture ratio of each of the mesh wiring portion 20 and the dummy wiring portion 30 can be set within a range from, for example, 85% inclusive to 99.9% inclusive.

Furthermore, the aperture ratio of the mesh wiring portion 20 and the dummy wiring portion 30 as a whole (the aperture ratio of a combination of the mesh wiring portion 20 and the dummy wiring portion 30) can be set within a range from, for example, 87% inclusive to 100% exclusive. Setting the aperture ratio A3 of the wiring board 10 as a whole within this range ensures sufficient conductivity and transparency of the wiring board 10.

The term "aperture ratio" means an area-size ratio (%) of an open area to unit area of a predetermined area. The predetermined area mentioned here is the mesh wiring portion 20, the dummy wiring portion 30, or the mesh wiring portion 20 and the dummy wiring portion 30. The open area is an area where no metal portion such as the first-direction wiring line 21, the second-direction wiring line 22, or the dummy wiring line 30a, etc. exists and therefore the substrate 11 is exposed.

Referring back to Fig. 1, the power feeding portion 40 is electrically connected to the mesh wiring portions 20. The power feeding portion 40 is a thin conductive member having a substantially rectangular shape. The longer-side direction of the power feeding portion 40 is parallel to the X direction. The shorter-side direction of the power feeding portion 40 is parallel to the Y direction. The power feeding portion 40 is arranged at the longer-side end (the negative-side end in the Y direction) of the substrate 11. For example, a metal material (including alloy) such as gold, silver, copper, platinum, tin, aluminum, iron, nickel, or the like can be used as the material of the power feeding portion 40. The power feeding portion 40 is electrically connected to a wireless communication circuit 92 of the image display device 90 when the wiring board 10 has been integrated in the image display device 90 (see Fig. 7). The power feeding portion 40 is provided in/on the front surface of the substrate 11, but is not limited thereto. A part or a whole of the power feeding portion 40 may be located outside the edge of the substrate 11.

### [Method of Manufacturing Wiring Board]

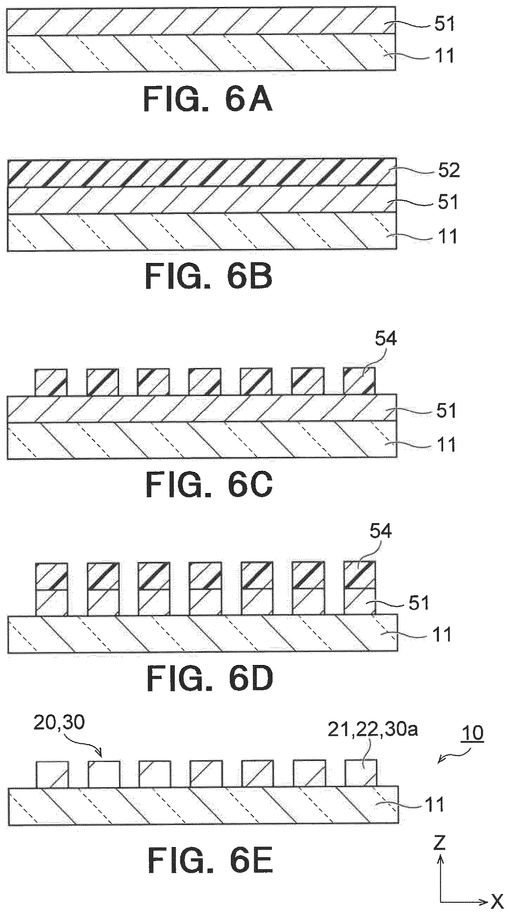

Next, with reference to Figs. 6A to 6E, a method of manufacturing a wiring board according to the present embodiment will now be described. Figs. 6A to 6E are cross-sectional views of a method of manufacturing a wiring board according to the present embodiment.

First, a substrate 11 that has transparency is prepared.

Next, a mesh wiring portion 20, and a dummy wiring portion 30 arranged around the mesh wiring portion 20, are formed on the substrate 11. The mesh wiring portion 20 includes a plurality of first-direction wiring lines 21 and a plurality of second-direction wiring lines 22. The dummy wiring portion 30 includes a plurality of dummy wiring lines 30a electrically independent of the first-direction wiring lines 21 and the second-direction wiring lines 22. In this process, first, as illustrated in Fig. 6A, a layer of a metal foil 51 is formed at substantially the entire area on the front surface of the substrate 11. In the present embodiment, the thickness of the metal foil 51 may be 0.1 µm or greater and 5.0 µm or less. In the present embodiment, the metal foil 51 may contain copper.

Next, as illustrated in Fig. 6B, a photo-curable insulating resist 52 is supplied to substantially the entire area over the front surface of the metal foil 51. The photo-curable insulating resist 52 is, for example, organic resin such as acrylic resin or epoxy-based resin.

Then, as illustrated in Fig. 6C, an insulating layer 54 is formed by photolithography. In this case, the insulating layer 54 (resist pattern) is formed by patterning the photo-curable insulating resist 52 by photolithography. In this process, the insulating layer 54 is formed in such a way as to expose the metal foil 51 corresponding to the first-direction wiring lines 21, the second-direction wiring lines 22, and the dummy wiring lines 30a.

Next, as illustrated in Fig. 6D, the metal foil 51 on the front surface of the substrate 11 is removed. In this process, the metal foil 51 is etched away in such a way as to expose the front surface of the substrate 11 by performing a wet process using ferric chloride, cupric chloride, a strong acid such as sulfuric acid or hydrochloric acid, a persulfate, hydrogen peroxide, or an aqueous solution thereof, or a combination thereof, etc.

Then, as illustrated in Fig. 6E, the insulating layer 54 is removed. In this case, the insulating layer 54 on the metal foil 51 is removed by a wet process using a permanganate solution, N-methyl-2-pyrrolidone, an acid solution, or an alkaline solution, or a dry process using oxygen plasma.

The wiring board 10 that includes the substrate 11 and includes the mesh wiring portion 20 and the dummy wiring portion 30 that are arranged on the substrate 11 can be obtained in this way. In this case, the mesh wiring portion 20 includes the first-direction wiring line 21 and the second-direction wiring line 22, and the dummy wiring portion 30 includes the dummy wiring line 30a.

### [Operational Effects of Present Embodiment]

Next, the operational effects of a wiring board having the configuration described above will now be explained.

As illustrated in Fig. 7, the wiring board 10 is integrated into the image display device 90 that includes the display 91. The wiring board 10 is disposed on the display 91. An example of such an image display device 90 is a portable terminal device such as a smartphone or a tablet. The mesh wiring portion 20 of the wiring board 10 is electrically connected to the wireless communication circuit 92 of the image display device 90 via the power feeding portion 40. By this means, it is possible to transmit and receive a radio wave having a predetermined frequency via the mesh wiring portion 20 and perform communication using the image display device 90. Note that the dummy wiring portion 30 is away from, and is electrically independent of, the mesh wiring portion 20. Therefore, even though the dummy wiring portion 30 is provided, it will not affect the transmission and reception of a radio wave.

According to the present embodiment, the wiring board 10 includes the substrate 11 that has transparency and the mesh wiring portion 20 arranged on the substrate 11 and including the plurality of first-direction wiring lines 21 and the plurality of second-direction wiring lines 22; therefore, sufficient transparency of the wiring board 10 is ensured. For this reason, the display 91 is viewable through the openings 23 of the mesh wiring portion 20 when the wiring board 10 is disposed on the display 91. Therefore, viewability of the display 91 is not impaired.

The dummy wiring portion 30 that includes the plurality of dummy wiring lines 30a electrically independent of the first-direction wiring lines 21 and the second-direction wiring lines 22 is arranged around the mesh wiring portion 20. The mesh wiring portion 20 is comprised of an iterative array of the predetermined unit pattern 20A in the Y direction. In the Y direction, the gap G₁ between the mesh wiring portion 20 and the dummy wiring portion 30 is 0.01 times or more and 0.2 times or less the pitch P_{b} of the unit pattern 20A in the Y direction. Since the gap G₁ is 0.01 times or more the pitch P_{b} as just described, it is possible to effectively suppress the dummy wiring line 30a of the dummy wiring portion 30 from having an influence on the transmission and reception of a radio wave at the mesh wiring portion 20. For this reason, it is possible to suppress a decrease in antenna performance. Moreover, since the gap G₁ is 0.2 times or less the pitch P_{b}, it is possible to make the boundary between the mesh wiring portion 20 and the dummy wiring portion 30 obscure in the Y direction. Therefore, it is possible to make the mesh wiring portion 20 and the dummy wiring portion 30 more invisible on the surface of the display 91 and make it harder for the user of the image display device 90 to notice the mesh wiring portion 20 and the dummy wiring portion 30 with the naked eye.

For the purpose of suppressing a decrease in antenna performance, it is preferable to increase the gap between the mesh wiring portion 20 and the dummy wiring portion 30. On the other hand, if the gap between the mesh wiring portion 20 and the dummy wiring portion 30 is increased, there is a possibility that, undesirably, the boundary between the mesh wiring portion 20 and the dummy wiring portion 30 might become clear. To address this issue, according to the present embodiment, in the Y direction, the gap G₁ between the mesh wiring portion 20 and the dummy wiring portion 30 is configured to be 0.01 times or more and 0.2 times or less the pitch P_{b} of the unit pattern 20A in the Y direction. This makes it possible to suppress a decrease in antenna performance while ensuring sufficient transparency of the wiring board 10.

Moreover, according to the present embodiment, in the X direction, the gap G₂ between the mesh wiring portion 20 and the dummy wiring portion 30 is configured to be 0.01 times or more and 0.2 times or less the pitch Pₐ of the unit pattern 20A in the X direction. Since the gap G₂ is 0.01 times or more the pitch Pₐ as just described, it is possible to effectively suppress the dummy wiring line 30a of the dummy wiring portion 30 from having an influence on the transmission and reception of a radio wave at the mesh wiring portion 20. For this reason, it is possible to suppress a decrease in antenna performance. Moreover, since the gap G₂ is 0.2 times or less the pitch Pₐ, it is possible to make the boundary between the mesh wiring portion 20 and the dummy wiring portion 30 obscure in the X direction. Therefore, it is possible to make the mesh wiring portion 20 and the dummy wiring portion 30 more invisible on the surface of the display 91 and make it harder for the user of the image display device 90 to notice the mesh wiring portion 20 and the dummy wiring portion 30 with the naked eye.

Furthermore, according to the present embodiment, the shape of the dummy unit pattern 30A is identical to the shape of the unit pattern 20A. This makes it possible to further increase the obscurity of the boundary between the mesh wiring portion 20 and the dummy wiring portion 30, thereby making it harder for the mesh wiring portion 20 and the dummy wiring portion 30 to be noticed with the naked eye on the surface of the display 91.

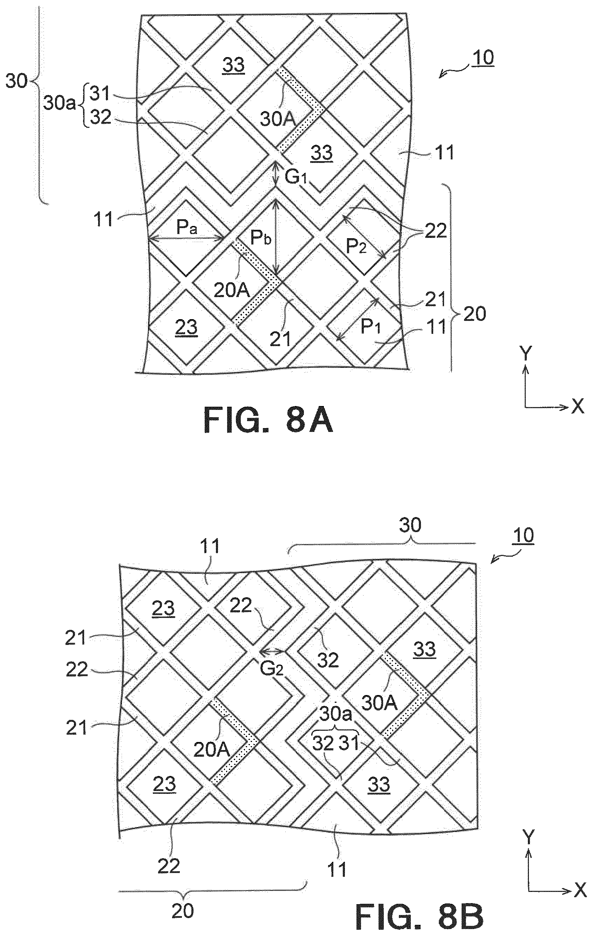

Although it has been described in the above embodiment that the first-direction wiring line 21 extends in the Y direction and the second-direction wiring line 22 extends in the X direction, the scope of disclosure is not limited to this example. For example, as illustrated in Figs. 8A and 8B, each of the first-direction wiring line 21 and the second-direction wiring line 22 may be configured to be not parallel to the X direction nor to the Y direction. In this case, the first-direction wiring line 21 and the second-direction wiring line 22 intersect obliquely, and each of the openings 23 is shaped like a rhombus in a plan view. Each of the first-direction wiring line 21 and the second-direction wiring line 22 is not parallel to the X direction nor to the Y direction.

Each of the first dummy wiring portions 31 of the dummy wiring portion 30 may extend in parallel with the first-direction wiring line 21. Similarly, the second dummy wiring portion 32 of the dummy wiring portion 30 may extend in parallel with the second-direction wiring line 22.

Also in this modification example, in the Y direction, the gap G₁ between the mesh wiring portion 20 and the dummy wiring portion 30 is 0.01 times or more and 0.2 times or less the pitch P_{b} of the unit pattern 20A in the Y direction. Moreover, in the X direction, the gap G₂ between the mesh wiring portion 20 and the dummy wiring portion 30 is 0.01 times or more and 0.2 times or less the pitch Pₐ of the unit pattern 20A in the X direction. This makes it possible to suppress a decrease in antenna performance. In addition, this makes it possible to make the boundary between the mesh wiring portion 20 and the dummy wiring portion 30 obscure. Therefore, it is possible to make the mesh wiring portion 20 and the dummy wiring portion 30 more invisible on the surface of the display 91 and make it harder for the user of the image display device 90 to notice the mesh wiring portion 20 and the dummy wiring portion 30 with the naked eye.

### Second Embodiment

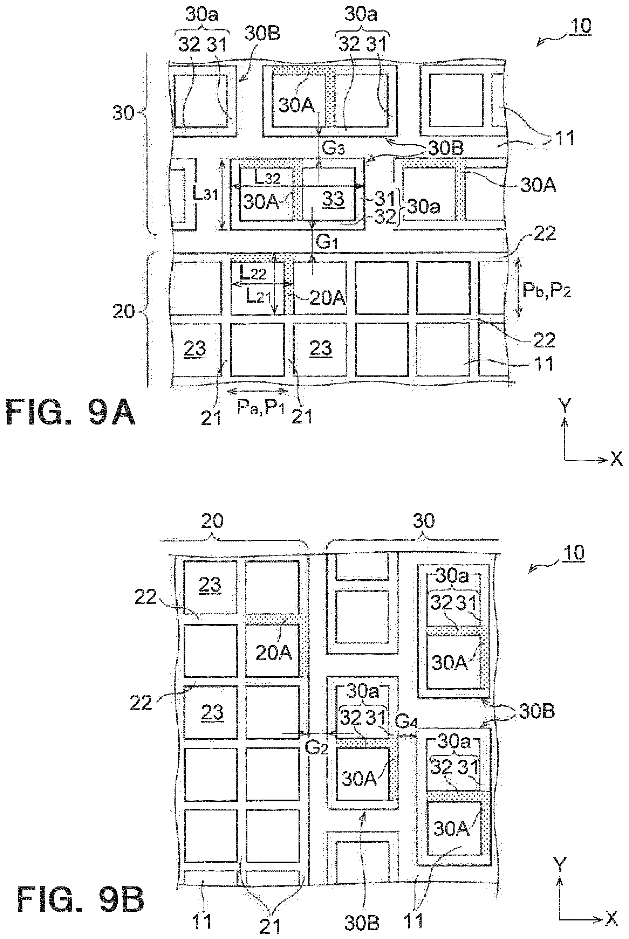

Next, with reference to Figs. 9A and 9B, a second embodiment will now be described. The second embodiment illustrated in Figs. 9A and 9B is different from the first embodiment mainly in that the dummy wiring portion 30 is comprised of a plurality of isolated patterns 30B independent of one another. In Figs. 9A and 9B, the same reference signs are assigned to the same portions as those of the first embodiment, and a detailed explanation will be omitted.

As illustrated in Figs. 9A and 9B, in the present embodiment, the dummy wiring portion 30 is comprised of a plurality of isolated patterns 30B independent of one another. The isolated pattern 30B is configured by the dummy wiring lines 30a that includes the first dummy wiring portion 31 extending in the Y direction and the second dummy wiring portion 32 extending in the X direction.

In addition, similarly in the present embodiment, at the isolated pattern 30B, openings 33 are formed by being surrounded by the first dummy wiring portions 31 arranged adjacent to one another and by the second dummy wiring portions 32 arranged adjacent to one another. In the illustrated example, two openings 33 are formed at the isolated pattern 30B. Each of the openings 33 has a substantially square shape in a plan view. In addition, at the isolated patterns 30B, the openings 33 are arranged each in the X direction or the Y direction. For example, as illustrated in Fig. 9A, at the isolated patterns 30B located adjacent to the mesh wiring portion 20 in the Y direction, the openings 33 are arranged each in the X direction. In addition, as illustrated in Fig. 9B, at the isolated patterns 30B located adjacent to the mesh wiring portion 20 in the X direction, the openings 33 are arranged each in the Y direction. Without being limited to this example, the openings 33 of the isolated patterns 30B located adjacent to the mesh wiring portion 20 in the Y direction may be arranged each in the Y direction. Moreover, the openings 33 of the isolated patterns 30B located adjacent to the mesh wiring portion 20 in the X direction may be arranged each in the X direction. The isolated patterns 30B have the same shape as one another. Moreover, the isolated patterns 30B may be arranged regularly or irregularly. Furthermore, a single opening 33 may be formed at the isolated pattern 30B, or three or more openings 33 may be formed thereat.

The isolated pattern 30B includes the dummy unit pattern 30A. In addition, the shape of the dummy unit pattern 30A is identical to the shape of the unit pattern 20A. This makes it possible to further increase the obscurity of the boundary between the mesh wiring portion 20 and the dummy wiring portion 30. Though not illustrated, the shape of the dummy unit pattern 30A and the shape of the unit pattern 20A may be different from each other.

In the present embodiment, the length of the dummy wiring line 30a of the isolated pattern 30B (hereinafter referred to also as "length L_{30B}") is 4.0 times or less the length of the first-direction wiring line 21 and the second-direction wiring line 22 of the unit pattern 20A (hereinafter referred to also as "length L_{20A}"). In this specification, the length L_{30B} of the dummy wiring line 30a is the sum of the length of each of the first dummy wiring portions 31 of the dummy wiring line 30a and the length of each of the second dummy wiring portions 32 of the dummy wiring line 30a. In the example illustrated in Fig. 9A, an equation of L_{30B} = 3 × L₃₁ + 2 × L₃₂ holds. In addition, in this specification, the length L_{20A} of the first-direction wiring line 21 and the second-direction wiring line 22 of the unit pattern 20A is the sum of the length of the first-direction wiring line 21 of the unit pattern 20A and the length of the second-direction wiring line 22 of the unit pattern 20A. In the example illustrated in Fig. 9A, an equation of L_{21A} = L₂₁ + L₂₂ holds. As mentioned above, in the present embodiment, the length L_{30B} of the dummy wiring line 30a of the isolated pattern 30B is 4.0 times or less the length L_{20A} of the first-direction wiring line 21 and the second-direction wiring line 22 of the unit pattern 20A. This makes it possible to effectively suppress the dummy wiring line 30a of the dummy wiring portion 30 from having an influence on the transmission and reception of a radio wave at the mesh wiring portion 20. For this reason, it is possible to suppress a decrease in antenna performance. Moreover, it is possible to make it harder for the difference between the mesh wiring portion 20 and the dummy wiring portion 30 to be visually perceived.

Moreover, in the Y direction (first direction), the gap G₃ between the isolated patterns 30B is 0.01 times or more and 0.2 times or less the pitch P_{b} of the unit pattern 20A in the Y direction (first direction). Since the gap G₃ is 0.01 times or more the pitch P_{b}, it is possible to suppress a decrease in antenna performance. Moreover, since the gap G₃ is 0.2 times or less the pitch P_{b}, it is possible to make it harder for the difference between the isolated patterns 30B to be visually perceived in the Y direction.

Similarly, in the X direction (second direction), the gap G₄ between the isolated patterns 30B is 0.01 times or more and 0.2 times or less the pitch Pₐ of the unit pattern 20A in the X direction (second direction). Since the gap G₄ is 0.01 times or more the pitch Pₐ, it is possible to suppress a decrease in antenna performance. Moreover, since the gap G₄ is 0.2 times or less the pitch Pₐ, it is possible to make it harder for the difference between the isolated patterns 30B to be visually perceived in the X direction.

Also in the present embodiment, it is possible to manufacture the wiring board 10 by using the method illustrated in Figs. 6A to 6E.

As explained above, according to the present embodiment, the length L_{30B} of the dummy wiring line 30a of the isolated pattern 30B is 4.0 times or less the length L_{20A} of the first-direction wiring line 21 and the second-direction wiring line 22 of the unit pattern 20A. This makes it possible to effectively suppress the dummy wiring line 30a of the dummy wiring portion 30 from having an influence on the transmission and reception of a radio wave at the mesh wiring portion 20. For this reason, it is possible to suppress a decrease in antenna performance. Moreover, it is possible to make it harder for the difference between the mesh wiring portion 20 and the dummy wiring portion 30 to be visually perceived.

Moreover, in the Y direction (first direction), the gap G₃ between the isolated patterns 30B is 0.01 times or more and 0.2 times or less the pitch P_{b} of the unit pattern 20A in the Y direction (first direction). Since the gap G₃ is 0.01 times or more the pitch P_{b} as just described, it is possible to suppress a decrease in antenna performance. Moreover, since the gap G₃ is 0.2 times or less the pitch P_{b}, it is possible to make it harder for the difference between the isolated patterns 30B to be visually perceived in the Y direction.

Moreover, according to the present embodiment, in the X direction (second direction), the gap G₄ between the isolated patterns 30B is 0.01 times or more and 0.2 times or less the pitch Pₐ of the unit pattern 20A in the X direction (second direction). Since the gap G₄ is 0.01 times or more the pitch Pₐ as just described, it is possible to suppress a decrease in antenna performance. Moreover, since the gap G₄ is 0.2 times or less the pitch Pₐ, it is possible to make it harder for the difference between the isolated patterns 30B to be visually perceived in the X direction.

Furthermore, according to the present embodiment, the isolated pattern 30B includes the dummy unit pattern 30A, and the shape of the dummy unit pattern 30A is identical to the shape of the unit pattern 20A. This makes it possible to further increase the obscurity of the boundary between the mesh wiring portion 20 and the dummy wiring portion 30, thereby making it harder for the mesh wiring portion 20 and the dummy wiring portion 30 to be noticed with the naked eye on the surface of the display 91.

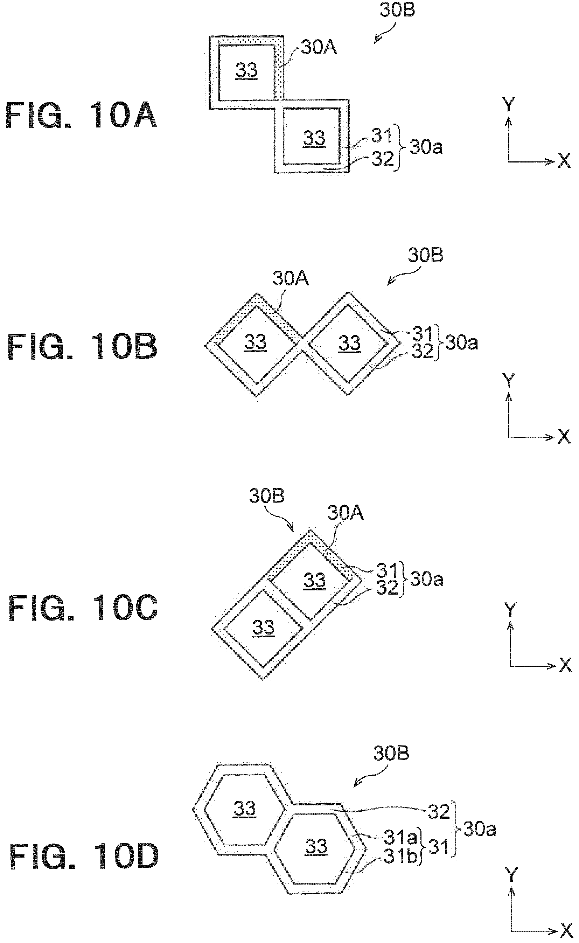

Although it has been described in the above embodiment that the openings 33 of the isolated patterns 30B are arranged each in the X direction or the Y direction, the scope of disclosure is not limited to this example. For example, as illustrated in Fig. 10A, the openings 33 may be arranged with a shift in the X direction and the Y direction.

Although it has been described in the above embodiment that the first dummy wiring portion 31 extends in the Y direction and the second dummy wiring portion 32 extends in the X direction, the scope of disclosure is not limited to this example. For example, as illustrated in Figs. 10B and 10C, each of the first dummy wiring portion 31 and the second dummy wiring portion 32 may be configured to be not parallel to the X direction nor to the Y direction. In this case, the first dummy wiring portion 31 and the second dummy wiring portion 32 may intersect obliquely, and each of the openings 33 may be shaped like a rhombus in a plan view.

Moreover, the openings 33 of the isolated pattern 30B may be arranged in the X direction as illustrated in Fig. 10B (or in the Y direction (not illustrated)). The openings 33 may be arranged with a shift in the X direction and the Y direction as illustrated in Fig. 10C.

Though not illustrated, the first-direction wiring line 21 of the mesh wiring portion 20 may extend in parallel with the first dummy wiring portion 31 or extend not in parallel therewith. Similarly, the second-direction wiring line 22 of the mesh wiring portion 20 may extend in parallel with the second dummy wiring portion 32 or extend not in parallel therewith.

Furthermore, as illustrated in Fig. 10D, the first dummy wiring portion 31 may include a first portion 31a that is not parallel to the X direction nor to the Y direction and a second portion 31b that is not parallel to the X direction nor to the Y direction and intersects with the first portion 31a obliquely. In addition, each of the openings 33 may have a substantially equilateral hexagonal shape in a plan view. In this case, the openings 33 may be arranged with a shift in the X direction and the Y direction. Though not illustrated, the openings 33 may be arranged in the X direction or the Y direction. Though not illustrated, the opening 33 may have a polygonal shape such as a substantially equilateral triangular shape or a substantially equilateral pentagonal shape, etc. in a plan view.

## Claims

1. A wiring board (10), comprising:
a substrate (11) having transparency;
a mesh wiring portion (20) arranged on the substrate (11) and including a plurality of wiring lines (21, 22); and
a dummy wiring portion (30) arranged around the mesh wiring portion (20) and including a plurality of dummy wiring lines (30a) electrically independent of the wiring lines (21, 22), wherein
the mesh wiring portion (20) is comprised of an iterative array of a predetermined unit pattern (20A) in a first direction (Y),
the dummy wiring portion (30) is comprised of a plurality of isolated patterns (30B) independent of one another,
the isolated patterns (30B) have the same shape as one another,
at the isolated pattern (30B), openings (33) are formed by being surrounded by the dummy wiring lines (30a),
a length (L_{30B}) of the dummy wiring line (30a) of the isolated pattern (30B) is 4.0 times or less a length (L_{20A}) of the wiring line (21, 22) of the unit pattern (20A), and
in the first direction (Y), a gap (G₃) between the isolated patterns (30B) is 0.01 times or more and 0.2 times or less a pitch (P_{b}) of the unit pattern (20A) in the first direction (Y).

2. The wiring board (10) according to claim 1, wherein
in the first direction (Y), a gap (G₁) between the mesh wiring portion (20) and the dummy wiring portion (30) is 0.01 times or more and 0.2 times or less a pitch (P_{b}) of the unit pattern (20A) in the first direction (Y).

3. The wiring board (10) according to claim 1 or 2, wherein
the unit pattern (20A) is arranged iteratively in a second direction (X) different from the first direction (Y), and
in the second direction (X), a gap (G₄) between the isolated patterns (30B) is 0.01 times or more and 0.2 times or less a pitch (Pₐ) of the unit pattern (20A) in the second direction (X).

4. The wiring board (10) according to claim 3, wherein
in the second direction (X), a gap (G₂) between the mesh wiring portion (20) and the dummy wiring portion (30) is 0.01 times or more and 0.2 times or less a pitch (Pₐ) of the unit pattern (20A) in the second direction (X).

5. The wiring board (10) according to any of claims 1 to 4, wherein
the isolated pattern (30B) includes a dummy unit pattern (30A), and
a shape of the dummy unit pattern (30A) is identical to a shape of the unit pattern (20A).

6. The wiring board (10) according to any of claims 1 to 5, said wiring board (10) having a radio-wave transmitting-and-receiving function.

7. A method of manufacturing a wiring board (10), comprising:
preparing a substrate (11) having transparency; and
forming a mesh wiring portion (20) and a dummy wiring portion (30) on the substrate (11), the mesh wiring portion (20) including a plurality of wiring lines (21, 22), the dummy wiring portion (30) being arranged around the mesh wiring portion (20) and including a plurality of dummy wiring lines (30a) electrically independent of the wiring lines (21, 22), wherein
the mesh wiring portion (20) is comprised of an iterative array of a predetermined unit pattern (20A) in a first direction (Y),
the dummy wiring portion (30) is comprised of isolated patterns (30B) independent of one another,
the isolated patterns (30B) have the same shape as one another,
at the isolated pattern (30B), openings (33) are formed by being surrounded by the dummy wiring lines (30a),
a length (L_{30B}) of the isolated pattern (30B) is 4.0 times or less a length (L_{20A}) of the unit pattern (20A), and
in the first direction (Y), a gap (G₃) between the isolated patterns (30B) is 0.01 times or more and 0.2 times or less a pitch (P_{b}) of the unit pattern (20A) in the first direction (Y).

## Patentansprüche

1. Leiterplatte (10), umfassend:
ein transparentes Substrat (11);
einen Netzverdrahtungsabschnitt (20), der auf dem Substrat (11) angeordnet ist und der eine Vielzahl von Verdrahtungslinien (21, 22) einschließt; und
einen um den Netzverdrahtungsabschnitt (20) herum angeordneten Dummy-Verdrahtungsabschnitt (30), der eine Vielzahl von Dummy-Verdrahtungslinien (30a) umfasst, die von den Verdrahtungslinien (21, 22) elektrisch unabhängig sind, wobei der Netzverdrahtungsabschnitt (20) aus einer iterativen Anordnung eines vorbestimmten Einheitsmusters (20A) in einer ersten Richtung (Y) aufgebaut ist, der Dummy-Verdrahtungsabschnitt (30) aus einer Vielzahl von voneinander unabhängigen, isolierten Mustern (30B) aufgebaut ist,
die isolierten Muster (30B) untereinander dieselbe Form aufweisen,
bei dem isolierten Muster (30B) Öffnungen (33) ausgebildet sind, die von den Dummy-Verdrahtungslinien (30a) umgeben sind,
eine Länge (L_{30B}) der Dummy-Verdrahtungslinie (30a) des isolierten Musters (30B) höchstens das 4,0-Fache einer Länge (L_{20A}) der Verdrahtungslinie (21, 22) des Einheitsmusters (20A) beträgt, und
in der ersten Richtung (Y) ein Abstand (G₃) zwischen den isolierten Mustern (30B) mindestens das 0,01-Fache und höchstens das 0,2-Fache eines Pitch (P_{b}) des Einheitsmusters (20A) in der ersten Richtung (Y) beträgt.

2. Leiterplatte (10) nach Anspruch 1, wobei
in der ersten Richtung (Y) ein Abstand (G₁) zwischen dem Netzverdrahtungsabschnitt (20) und dem Dummy-Verdrahtungsabschnitt (30) mindestens das 0,01-Fache und höchstens das 0,2-Fache eines Pitch (P_{b}) des Einheitsmusters (20A) in der ersten Richtung (Y) beträgt.

3. Leiterplatte (10) nach Anspruch 1 oder 2, wobei
das Einheitsmuster (20A) in einer zweiten Richtung (X), die sich von der ersten Richtung (Y) unterscheidet, iterativ angeordnet ist, und
in der zweiten Richtung (X) ein Abstand (G₄) zwischen den isolierten Mustern (30B) mindestens das 0,01-Fache und höchstens das 0,2-Fache eines Pitch (Pₐ) des Einheitsmusters (20A) in der zweiten Richtung (X) beträgt.

4. Leiterplatte (10) nach Anspruch 3, wobei
in der zweiten Richtung (X) ein Abstand (G₂) zwischen dem Netzverdrahtungsabschnitt (20) und dem Dummy-Verdrahtungsabschnitt (30) mindestens das 0,01-Fache und höchstens das 0,2-Fache eines Pitch (Pₐ) des Einheitsmusters (20A) in der zweiten Richtung (X) beträgt.

5. Leiterplatte (10) nach einem der Ansprüche 1 bis 4, wobei
das isolierte Muster (30B) ein Dummy-Einheitsmuster (30A) umfasst und
eine Form des Dummy-Einheitsmusters (30A) mit einer Form des Einheitsmusters (20A) identisch ist.

6. Leiterplatte (10) nach einem der Ansprüche 1 bis 5, wobei die Leiterplatte (10) eine Funktion zum Senden und Empfangen von Funkwellen aufweist.

7. Verfahren zur Herstellung einer Leiterplattes (10), umfassend:
Bereitstellen eines transparenten Substrats (11); und
Ausbilden eines Netzverdrahtungsabschnitts (20) und eines Dummy-Verdrahtungsabschnitts (30) auf dem Substrat (11), wobei der Netzverdrahtungsabschnitt (20) eine Vielzahl von Verdrahtungslinien (21, 22) umfasst und der Dummy-Verdrahtungsabschnitt (30) um den Netzverdrahtungsabschnitt (20) herum angeordnet ist und eine Vielzahl von Dummy-Verdrahtungslinien (30a) umfasst, die von den Verdrahtungslinien (21, 22) elektrisch unabhängig sind, wobei
der Netzverdrahtungsabschnitt (20) aus einer iterativen Anordnung eines vorbestimmten Einheitsmusters (20A) in einer ersten Richtung (Y) aufgebaut ist, der Dummy-Verdrahtungsabschnitt (30) aus voneinander unabhängigen, isolierten Mustern (30B) aufgebaut ist,
die isolierten Muster (30B) untereinander dieselbe Form aufweisen,
bei dem isolierten Muster (30B) Öffnungen (33) ausgebildet sind, die von den Dummy-Verdrahtungslinien (30a) umgeben sind,
eine Länge (L_{30B}) des isolierten Musters (30B) höchstens das 4,0-Fache einer Länge (L_{20A}) des Einheitsmusters (20A) beträgt, und
in der ersten Richtung (Y) ein Abstand (G₃) zwischen den isolierten Mustern (30B) mindestens das 0,01-Fache und höchstens das 0,2-Fache eines Pitch (P_{b}) des Einheitsmusters (20A) in der ersten Richtung (Y) beträgt.

## Revendications

1. Carte de câblage (10), comprenant :
un substrat (11) présentant une transparence ;
une portion de câblage maillé (20) disposée sur le substrat (11) et comportant une pluralité de lignes de câblage (21, 22) ; et
une portion de câblage factice (30) disposée autour de la portion de câblage maillé (20) et comportant une pluralité de lignes de câblage factices (30a) électriquement indépendantes des lignes de câblage (21, 22), dans laquelle
la portion de câblage maillé (20) est constituée d'un agencement répétitif d'un motif unitaire prédéterminé (20A) dans une première direction (Y),
la portion de câblage factice (30) est constituée d'une pluralité de motifs isolés (30B) indépendants les uns des autres,
les motifs isolés (30B) ont la même forme les uns que les autres,
au niveau du motif isolé (30B), des ouvertures (33) sont formées en étant entourées par les lignes de câblage factices (30a),
une longueur (*L*_{30*B*}) de la ligne de câblage factice (30a) du motif isolé (30B) est inférieure ou égale à 4,0 fois une longueur (*L*_{20*A*}) de la ligne de câblage (21, 22) du motif unitaire (20A), et
dans la première direction (Y), un espacement (*G*₃) entre les motifs isolés (30B) est supérieur ou égal à 0,01 fois et inférieur ou égal à 0,2 fois un pas (*P_{b}*) du motif unitaire (20A) dans la première direction (Y).

2. Carte de câblage (10) selon la revendication 1, dans laquelle
dans la première direction (Y), un espacement (*G*₁) entre la portion de câblage maillé (20) et la portion de câblage factice (30) est supérieur ou égal à 0,01 fois et inférieur ou égal à 0,2 fois un pas (*P_{b}*) du motif unitaire (20A) dans la première direction (Y).

3. Carte de câblage (10) selon la revendication 1 ou 2, dans laquelle
le motif unitaire (20A) est disposé de manière répétée dans une deuxième direction (X) différente de la première direction (Y), et
dans la deuxième direction (X), un espacement (*G*₄) entre les motifs isolés (30B) est supérieur ou égal à 0,01 fois et inférieur ou égal à 0,2 fois un pas (*Pₐ*) du motif unitaire (20A) dans la deuxième direction (X).

4. Carte de câblage (10) selon la revendication 3, dans laquelle
dans la deuxième direction (X), un espacement (*G*₂) entre la portion de câblage maillé (20) et la portion de câblage factice (30) est supérieur ou égal à 0,01 fois et inférieur ou égal à 0,2 fois un pas (*Pₐ*) du motif unitaire (20A) dans la deuxième direction (X).

5. Carte de câblage (10) selon l'une quelconque des revendications 1 à 4, dans laquelle
le motif isolé (30B) comporte un motif unitaire factice (30A), et
une forme du motif unitaire factice (30A) est identique à une forme du motif unitaire (20A).

6. Carte de câblage (10) selon l'une quelconque des revendications 1 à 5, ladite carte de câblage (10) présentant une fonction d'émission et de réception d'ondes radio.

7. Procédé de fabrication d'une carte de câblage (10), comprenant :
la préparation d'un substrat (11) présentant une transparence ; et
la formation d'une portion de câblage maillé (20) et d'une portion de câblage factice (30) sur le substrat (11), la portion de câblage maillé (20) comportant une pluralité de lignes de câblage (21, 22), la portion de câblage factice (30) étant disposée autour de la portion de câblage maillé (20) et comportant une pluralité de lignes de câblage factices (30a) électriquement indépendantes des lignes de câblage (21, 22), dans lequel
la portion de câblage maillé (20) est constituée d'un agencement répétitif d'un motif unitaire prédéterminé (20A) dans une première direction (Y),
la portion de câblage factice (30) est constituée de motifs isolés (30B) indépendants les uns des autres,
les motifs isolés (30B) ont la même forme les uns que les autres,
au niveau du motif isolé (30B), des ouvertures (33) sont formées en étant entourées par les lignes de câblage factices (30a),
une longueur (*L*_{30*B*}) du motif isolé (30B) est inférieure ou égale à 4,0 fois une longueur (*L*_{20*A*}) du motif unitaire (20A), et
dans la première direction (Y), un espacement (*G*₃) entre les motifs isolés (30B) est supérieur ou égal à 0,01 fois et inférieur ou égal à 0,2 fois un pas (*P_{b}*) du motif unitaire (20A) dans la première direction (Y).
